# EUROPÄISCHE PATENTANMELDUNG

(11) **EP 4 336 191 A1**
(43) Veröffentlichungstag der Anmeldung: **13.03.2024**
(21) Anmeldenummer: 22194190.9
(22) Anmeldetag: 06.09.2022
(51) Int. Cl.: G01R 15/18

(54) **ANORDNUNG UND VERFAHREN ZUR ERFASSUNG EINES STROMS EINES ERSTEN STROMLEITERS EINER, INSBESONDERE ZUMINDEST TEILWEISE AUF EINER LEITERPLATTE AUFGEBRACHTEN, SCHALTUNG**

(71) Anmelder: Siemens Aktiengesellschaft, 80333 München (DE)
(72) Erfinder: Lager, Michael, 91074 Herzogenaurach (DE); Mondal, Gopal, 91058 Erlangen (DE); Nielebock, Sebastian, 91301 Forchheim (DE); Sirtl, Jennifer, 90763 Fürth (DE)
(74) Vertreter: Siemens Patent Attorneys

(57) **Zusammenfassung**

Die Erfindung betrifft eine Anordnung und ein Verfahren zur Erfassung eines Stroms direkt oder indirekt über eine Stromänderung eines ersten Stromleiters einer, insbesondere zumindest teilweise auf einer Leiterplatte aufgebrachten, Schaltung, bei der ein erfindungsgemäß realisierter und um den ersten Stromleiter platzierter Messwertaufnehmer in Verbindung mit einem angeschlossenen Transimpedanzverstärker in Verbindung mit der bei einer Stromflussänderung im ersten Stromleiter gegebenen Magnetflussänderung einen zu einer Stromänderung im ersten Stromleiter proportionalen Kurzschlussstrom erzeugt.

## Beschreibung

Die Erfindung betrifft eine Anordnung zur Erfassung eines Stroms eines ersten Stromleiters einer, insbesondere zumindest teilweise auf einer Leiterplatte aufgebrachten, Schaltung gemäß dem Oberbegriff des Anspruchs 1, Verfahren zur Erfassung eines Stroms eines ersten Stromleiters einer, insbesondere zumindest teilweise auf einer Leiterplatte aufgebrachten, Schaltung, gemäß dem Oberbegriff des Anspruchs 9.

Verfahren und Anordnungen zur Stromerfassung sind bekannt. Diese Ansätze unterscheiden sich in der Regel dadurch, dass es sich um unterschiedliche physikalische Effekte beruhende Messverfahren handelt. Beispiele hierfür sind die so genannte Shunt-Messung, eine Magnetfeld-Messung, beispielsweise das so genannte "Giant Magnetoresistance-", GMR-Effekt, nutzende Messverfahren, die Messung beruhend auf einer Rogowski-Spule oder die auf dem Stromtransformator-Ansatz beruhende Messung.

Die genannten Messverfahren und -anordnungen haben jedoch den Nachteil, dass sie in der Regel durch diverse Faktoren frequenzlimitiert sind, beispielsweise durch zu verwendende Kernmaterialien, Wickelkapazitäten und/oder Kompensationseinrichtungen.

Die der Erfindung zugrundeliegende Aufgabe ist es daher eine Lösung anzugeben, die die Nachteile des Standes der Technik überwindet, insbesondere ist es die Aufgabe der Erfindung ein Verfahren und eine Anordnung anzugeben, die eine einfache Realisierung, insbesondere bei Integration des Messverfahrens in einer Leiterplatte, ermöglicht.

Die Aufgabe wird durch die Anordnung Verfahren zur Erfassung eines Stroms eines ersten Stromleiters einer, insbesondere zumindest teilweise auf einer Leiterplatte aufgebrachten, Schaltung, gemäß Oberbegriff des Anspruchs 1, durch dessen kennzeichnende Merkmale, sowie durch das Verfahren zur Erfassung eines Stroms eines ersten Stromleiters einer, insbesondere zumindest teilweise auf einer Leiterplatte aufgebrachten, Schaltung, gemäß dem Oberbegriff des Anspruchs 9, durch dessen kennzeichnende Merkmale gelöst.

Weitere vorteilhafte Ausgestaltungen und Weiterbildungen der Erfindung sind durch die Unteransprüche angegeben.

Bei dem erfindungsgemäßen Verfahren zur Erfassung eines Stroms eines ersten Stromleiters einer, insbesondere zumindest teilweise auf einer Leiterplatte aufgebrachten, Schaltung, werden ein erster in einer Ebene einen geschlossenen Stromkreis ausbildender Strom leitender Körper und ein zweiter in der Ebene einen geschlossenen Stromkreis ausbildender Strom leitender Körper um den ersten Stromleiter derart platziert, dass die ausgebildeten Stromkreise der Körper in der Ebene konzentrisch, insbesondere kreisförmig, um den in ihrem geometrischen Mittelpunkt platzierten durch die Ebene senkrecht verlaufenden zu erfassenden Strom führenden ersten Stromleiter angeordnet und betrieben werden, wobei die Körper derart geformt werden und/oder funktional derart miteinander verbunden und betrieben werden, dass sie durch zumindest einen senkrecht zu der Ebene im Querschnitt ein U-Profil ausbildenden, zweiten Stromleiter leitend verbunden sind, wobei die beiden Schenkel des U-Profils im Querschnitt auf der jeweiligen Querschnittsebene liegen und der erste Schenkel des U-Profils mit dem ersten Körper über einen ersten Verbindungspunkt verbunden ist und der zweite Schenkel des U-Profils mit dem zweiten Körper über einen zweiten Verbindungspunkt verbunden ist, insbesondere jeweils der erste Verbindungspunkt und der zweite Verbindungspunkt des jeweiligen U-Profils mit dem Mittelpunkt auf einer Geraden liegt; ferner werden der erste Körper mit einem ersten Eingang eines, insbesondere durch einen Operationsverstärker ausgestalteten, Transimpedanzverstärkers und der zweite Körper mit einem zweiten Eingang des Transimpedanzverstärkers derart verbunden betrieben, dass durch den Transimpedanzverstärker ein Kurzschluss bewirkbar ist, wobei ein im Fall eines bewirkten Kurzschlusses durch den ersten Körper, den zweiten Körper und den ausgeformten und/oder funktional verbundenen zumindest einen zweiten Stromleiter fließende Kurzschlussstrom vom Transimpedanzverstärker als Eingangsgröße des Transimpedanzverstärkers eine Spannung an einem Ausgang des Transimpedanzverstärkers (Transimpedanzwandlers) erzeugt.

Dadurch, dass der erste und der zweite Körper sowie der funktional verbundene und/oder ausgeformte zumindest eine zweite Stromleiter, in erfindungsgemäßer Weise funktional verbunden und betrieben werden, wird in den dadurch gegebenen Wechselsstromkreis ein Strom induziert, wenn durch den ersten Stromleiter Strom fließt und weil der Transimpedanzverstärker derart funktional verbunden und betrieben wird, dass er mit dem ersten und zweiten Körper sowie dem zumindest einen zweiten Stromleiter in diesem Fall einen Kurzschluss erzeugt. Die Induktion ergibt sich, da der Wechselstrom des ersten Stromleiters ein magnetisches Feld H erzeugt, welches wiederum senkrecht die Masche des zweiten Stromleiters durchflutet. Der Wert des Stromes ändert sich entsprechend einer Änderung des Wertes des durch den ersten Stromleiter fließenden Stromes und liegt aufgrund der Verfahrensweise gemäß dem erfindungsgemäßen Verfahren so an dem Transimpedanzverstärker an, dass an dessen Ausgang eine zur Änderung des Kurzschlussstroms proportionale Spannung anliegt. Mit der Auswertung dieser Spannung kann also auf erfinderische und vorteilhafte Weise eine Stromänderung erfasst werden.

Durch das erfindungsgemäße Verfahren wird es insbesondere möglich, Stromerfassungsverfahren, vorzugsweise anders als nach Art der Messung auf Basis des aus dem Stand der Technik bekannten Rogowski-Spulen Ansatzes, die sensorbasiert sind, auf Leiterplatte zu implementieren, denn durch die erfindungsgemäße Verfahrensweise wird ein starkes Signal erzeugt, so dass bereits mit wenigen zweiten Stromleitern, insbesondere durch den erfindungsgemäßen Betrieb des Transimpedanzverstärkers sehr gut auswertbare zur Stromänderung proportionale Signale erzeugt werden. Im Gegensatz zu aus dem Stand der Technik bekannten Versuchen einer Implementierung des Rogowski-Spulen-Ansatzes sind erfindungsgemäße, also keine 100 bis zu einem Vielfachen von 100 Schleifen notwendig, um einen Strom zu erfassen, sondern eben nur die wenigen durch die zweiten Stromleiter sich aus der U-Form ergebenden Schleifen. Das erfindungsgemäße Verfahren reduziert damit massiv die nach dem Stand der Technik ansonsten notwendige sehr große Anzahl an Löchern in der Leiterplatte, reduziert zudem unter anderem dadurch auch den Aufwand und sorgt beim Design der Leiterplatte für deutlich mehr Freiheitsgrade.[SJ(PPD11]

Zudem wird durch die erfindungsgemäße Verfahrensweise eine galvanisch getrennte Stromerfassung ermöglicht. All dies ist, insbesondere bei einer Implementierung des Transimpedanzverstärkers durch einen Operationsverstärker gegeben, so dass hierdurch eine sehr gute Implementierungsvariante der möglichen Implementierungsvarianten gegeben ist.

Die erfindungsgemäß funktional verbundenen und betriebenen Elemente ermöglichen zudem eine flexible Anpassung an die Dimension des im ersten Stromleiter zu erwartenden, also des findungsgemäß zu erfassenden, Stromes.

Eine Ausrichtung der Verbindungspunkte auf den Leiter als Mittelpunkt ist zwar eine mögliche, beispielsweise bei Wunsch nach Symmetrien denkbare, Designoption aber für die erfindungsgemäße Stromerfassung nicht erforderlich, da das Signal, welches durch die Erfindung für die Stromerfassung erzeugt wird, durch die aufgespannte Fläche des Messnehmers durch die das H-Feld der zu erfassenden Stromänderung geht, gegeben ist.

Diese Vorteile gelten auch für die Weiterbildung des erfindungsgemäßen Verfahrens, bei dem der erste Körper und der zweite Körper derart funktional verbunden und betrieben werden, dass jeder Punkt des ersten geschlossenen Stromkreises mit dem parallelen Punkt des zweiten Stromkreises über eine im Querschnitt ein U-Profil ausbildende leitende Verbindung derart verbunden ist, dass ein um den Mittelpunkt umlaufender Querschnitt stets ein U-Profil aufweist, so dass der zumindest eine zweite Stromleiter mit dem ersten Körper und dem zweiten Körper als ein umlaufendes U-Profil ausbildender Hohlkörper ausgebildet ist.

Durch diese Lösung wird also der zumindest eine zweite Stromleiter aus dem ersten und zweiten Körper zu einem dreidimensionalen Gesamtgebilde ausgeformt. Man könnte diesen Körper auch quasi das Ergebnis einer Aneinanderreihung von unendlich vielen radial um den ersten Stromleiter angeordneten miteinander verschmolzenen zweiten Stromleiter betrachten, die vollständig den ersten Stromleiter umschließen und in denen das vom Wechselstrom des ersten Stromleiters erzeugte Magnetfeld in größerem Umfang durchdrungen wird. Man kann es auch als einen einzigen ausgeformten zweiten Stromleiter betrachten, der im Vergleich zu einem durch eine einzige Windung gegebenen zweiten Stromleiter anders vom Magnetfeld durchdrungen wird und schon allein deswegen andere Eigenschaften aufweist, die entsprechende Anforderungen an eine Implementierung erfüllen können. Weitere Vorteile dieser Anordnung können unter anderem eine größere Robustheit, vollständiges Fehlen von Bohrungen in Leiterplatten und/oder alternative Designoptionen sein.

Gemäß einer weiteren Weiterbildung des erfindungsgemäßen Verfahrens werden der erste Körper, der zweite Körper und/oder der zumindest eine zweite Stromleiter, zumindest teilweise als Leiterbahnen einer Leiterplatte betrieben. Hierdurch kann der Aufwand zum Bereitstellen des erfindungsgemäßen Verfahrens reduziert werden, da zumindest ein Teil der erfindungsgemäß notwendigen Verbindungen und Funktionseinheiten bereits bei Herstellen der Leiterbahnstruktur der Leiterplatte erzeugt wird und höchstens wenige Elemente bestückt werden müssen.

Vorzugsweise wird das erfindungsgemäße Verfahren dabei derart weitergebildet, dass der erste Stromleiter, der zumindest eine zweite Stromleiter und/oder die funktionalen Verbindungen als so genannte "Vertical Interconnect Access"-, Via-Verbindungen durch die Leiterplatte betrieben werden. Hierdurch können bereits bei Herstellung der Leiterplattenstruktur auch die gemäß erfinderischer Ausgestaltung für das erfindungsgemäße Verfahren der Stromerfassung erforderlichen horizontalen Elemente erzeugt werden, so dass ein Bestückungsaufwand noch weiter reduziert wird.

Gemäß einer Weiterbildung des erfindungsgemäßen Verfahrens werden der erste Körper, der zweite Körper und/oder der zumindest eine zweite Stromleiter derart ausgeformt und/oder funktional verbunden, dass er in Innenlayern der Leiterplatte betrieben wird. Diese Verfahrensweise nutzt zum einen auf vorteilhafte Weise eines der Potenziale des erfindungsgemäßen Verfahrens aus, welches in verbesserten Minimierungsmöglichkeiten liegt, und erlaubt es das erfindungsgemäße Verfahren quasi zumindest teilweise versteckt zu betreiben bzw. so zu betreiben, dass beispielsweise noch Raum für Schirmungen auf den so genannten Außenlayern ist oder zusätzliche Freiheitsgrade für Leiterbahnstrukturen auf den Außenlayern geboten werden, beispielsweise den Stromzweig, dessen Strom erfasst werden soll.

Bei der Weiterbildung des erfindungsgemäßen Verfahrens, wonach die Spannung am Ausgang des Transimpedanzverstärkers einem eine Integration durchführenden ersten Modul als Eingangssignale zugeführt wird, kann auf vorteilhafte Weise der Wert des erfassten Stromes ermittelt werden und nicht nur dessen Änderung. Hierdurch kann die Erfindung je nach gewünschter zu messender Größe betrieben werden und diese erfassbar machen.

Diese Weiterbildung des erfindungsgemäßen Verfahrens kann dabei je nach Anforderung an die Schaltung bzw. grundsätzlich nach gewünschtem Design vorteilhaft ausgestaltet werden, dass das erste Modul derart mit dem Transimpedanzverstärker funktional verbunden und betrieben wird, dass das Modul als Integratorschaltung wirkt. Eine Integratorschaltung ist eine einfache analoge Ausgestaltung zur Wandlung der erfassten Stromänderung in einen Stromwert, die durch die Aufintegration bewirkt wird.

Will man Bauteile einsparen und/oder die digital verarbeitbaren Signale als Ergebnis des erfindungsgemäßen Verfahrens zur Stromerfassung erhalten, kann das erfindungsgemäße Verfahren derart ausgestaltet werden, dass ein zweites Modul derart mit dem Transimpedanzverstärker funktional verbunden und betrieben wird, dass das zweite Modul als Analog/Digitalwandler wirkt, wobei der analoge Wert der Spannung am Ausgang des Transimpedanzverstärkers zu einer digitalen Repräsentation des Wertes der Spannung derart gewandelt und derart funktional mit einer, insbesondere als "Digital Signalling Processor", DSP, so genannten "Central Programming Unit", CPU, oder so genannten, "Application-Specific Integrated Circuit" Schaltung, ASIC, ausgestalteten, Recheneinheit verbunden und betrieben wird, dass die Integration durch die Recheneinheit erfolgt.

Bei der erfindungsgemäßen Anordnung zur Erfassung eines Stroms eines ersten Stromleiters einer, insbesondere zumindest teilweise auf einer Leiterplatte aufgebrachten, Schaltung, sind ein erster in einer Ebene einen geschlossenen Stromkreis ausbildender Strom leitender Körper und ein zweiter in der Ebene einen geschlossenen Stromkreis ausbildender Strom leitender Körper um den Leiter derart platziert, dass die ausgebildeten Stromkreise der Körper in der Ebene konzentrisch, insbesondere kreisförmig, um den in ihrem geometrischen Mittelpunkt platzierten durch die Ebene senkrecht verlaufenden den zu erfassenden Strom führenden ersten Stromleiter angeordnet sind, wobei die Körper derart geformt und/oder funktional derart miteinander verbunden sind, dass sie durch zumindest einen senkrecht zu der Ebene im Querschnitt ein U-Profil ausbildenden, zweiten Stromleiter leitend verbunden sind, wobei die beiden Schenkel des U-Profils im Querschnitt auf der jeweiligen Querschnittsebene liegen und der erste Schenkel des U-Profils mit dem ersten Körper über einen ersten Verbindungspunkt verbunden ist und der zweite Schenkel des U-Profils mit dem zweiten Körper über einen zweiten Verbindungspunkte verbunden ist, und wobei der erste Verbindungspunkt und der zweite Verbindungspunkt des U-Profils mit dem Mittelpunkt auf einer Geraden liegen; ferner sind der erste Körper mit einem ersten Eingang eines, insbesondere durch einen Operationsverstärker ausgestalteten, Transimpedanzverstärkers und der zweite Körper mit einem zweiten Eingang des Transimpedanzverstärkers derart ausgestaltet und verbunden, dass durch den Transimpedanzverstärker ein Kurzschluss bewirkbar ist, wobei ein im Fall eines bewirkten Kurzschlusses durch den ersten Körper, den zweiten Körper und den ausgeformten und/oder funktional verbundenen zumindest einen zweiten Stromleiter fließender Kurzschlussstrom vom Transimpedanzverstärker als Eingangsgröße des Transimpedanzverstärkers eine Spannung an einem Ausgang des Transimpedanzverstärkers erzeugt.

Die in Bezug auf das erfindungsgemäße Verfahren angeführten Vorteile und bevorzugten Ausgestaltungen und Weiterbildungen lassen sich dabei sinngemäß auf die erfindungsgemäße Anordnung übertragen und liegen zudem auch in der Tatsache, dass sie durch ihre Implementierung die Durchführung des Verfahrens erlauben.

Das Gleiche gilt auch für die im Folgenden angegebenen den Ausgestaltungen und Weiterbildungen des Verfahrens sinngemäß entsprechenden bevorzugten Ausgestaltungen und Weiterbildungen der erfindungsgemäßen Anordnung. Auch hier lassen sich die Vorteile mutatis mutandis übertragen, so dass sie, sofern keine weiteren Vorteile angegeben sind, zumindest diese Vorteile haben und sie zudem jeweils mindestens zusätzlich den Vorteil bieten die Durchführung der sinngemäß entsprechenden Ausgestaltungen und Weiterbildungen des erfindungsgemäßen Verfahrens zu ermöglichen.

Bei einer Ausgestaltung der erfindungsgemäßen Anordnung ist der erste Körper und der zweite Körper derart funktional verbunden und ausgestaltet, dass jeder Punkt des ersten geschlossenen Stromkreises mit dem parallelen Punkt des zweiten Stromkreises über eine im Querschnitt ein U-Profil ausbildende leitende Verbindung derart verbunden ist, dass ein um den Mittelpunkt umlaufender Querschnitt stets ein U-Profil aufweist, so dass der eine Stromleiter mit dem ersten Körper und dem zweiten Körper als ein umlaufendes U-Profil ausbildender Hohlkörper ausgebildet ist. Hierdurch wird der zur Stromänderung im Leiter proportionale Kurzschlussstrom in einem einstückigen Formteil induziert. Ein solches Formteil weist unter anderem den Vorteil auf, dass es beispielsweise den Aufwand beim Bestücken einer Schaltung mit der erfindungsgemäßen Anordnung zum Erfassen eines Stromes reduziert.

Bei einer Weiterbildung der erfindungsgemäßen Anordnung nach einem der vorherigen Ansprüche, ist/sind der erste Körper, der zweite Körper und/oder der zumindest eine zweite Stromleiter, zumindest teilweise als Leiterbahnen einer Leiterplatte ausgestaltet. Dies repräsentiert bzw. ermöglicht eine Integration der erfindungsgemäßen Anordnung auf einer mit für einen zu messenden Stromkreis vorgesehenen Leiterplatte.

Die erfindungsgemäße Anordnung kann bevorzugt derart weitergebildet werden, dass der erste Stromleiter, der zumindest eine zweite Stromleiter und/oder die funktionalen Verbindungen als so genannte "Vertical Interconnect Access"-, Via-Verbindungen durch die Leiterplatte ausgestaltet ist, hierdurch wird ebenfalls die Integration auf der Leiterplatte unterstützt und auf vorteilhafte Weise die Dicke der Leiterplatte für die Realisierung der Schenkel der zweiten Stromleiter genutzt, die zudem fast ausschließlich beim Auftragen der Leiterbahnstruktur der Leiterplatte erzeugt werden können.

Bei einer weiteren Ausgestaltung der erfindungsgemäßen Anordnung ist/sind der erste Körper, der zweite Körper und/oder der zumindest ein zweite Stromleiter derart ausgeformt und/oder funktional verbunden, dass er/sie in Innenlayern der Leiterplatte angeordnet ist/sind.

Gemäß der Weiterbildung der erfindungsgemäßen Anordnung, bei der die Spannung am Ausgang des Transimpedanzverstärkers einem eine Integration durchführenden Modul als Eingangssignal angelegt ist, wird das Signal, das das erfindungsgemäße Verfahren erzeugt, welches den Betrag einer Spannung darstellt, das proportional zur Stromänderung ist, in ein anderes Signal überführt, welches ebenfalls eine Spannung ist, die aber proportional zu dem Wert des durch den Leiter tatsächlich gerade fließenden Stromes ist. Dadurch geht die Erfindung über die reine Erfassung vom Vorhandensein von Strom im ersten Stromleiter, aufgrund von Änderungen, hin zur - durch die Proportionalität indirekten - Erfassung des Werts des tatsächlichen Stroms, der dann auch für Auswertung, Zustandsänderung und/oder Steuerungszwecke oder anderen aufgrund des Stroms ableitbaren Aktionen zur Verfügung steht.

Vorzugsweise wird die erfindungsgemäße Anordnung dabei derart weitergebildet, dass ein erstes Modul derart mit dem Transimpedanzverstärker funktional verbunden und ausgestaltet ist, dass das erste Modul als Integratorschaltung wirkt. Dies wird in der Regel eine Lösung darstellen, die in der Lage ist, die als analoges Signal gegebene Spannung, ebenfalls als analoges Signal auszugeben, so dass beim Design einer Schaltung, die die erfindungsgemäße Anordnung nutzt, und ein analoges Signal zur Weiterverarbeitung benötigt, dies bedient werden kann.

Alternativ ist die erfindungsgemäße Anordnung derart weitergebildet, dass ein zweites Modul mit dem Transimpedanzverstärker derart funktional verbunden und ausgestaltet ist, dass das zweite Modul als Analog/Digitalwandler wirkt, wobei der analoge Wert der Spannung am Ausgang des Transimpedanzverstärkers zu einer digitalen Repräsentation des Wertes der Spannung derart gewandelt und derart funktional einer, insbesondere als "Digital Signalling Processor"-, DSP-, so genannten "Central Programming Unit"-, CPU-, oder so genannten, "Application-Specific Integrated Circuit"-, ASIC-Schaltung, ausgestalteten, Recheneinheit als Eingangssignal angelegt ist, dass die Integration durch die Recheneinheit erfolgt. Hierdurch kann beim Design einer Schaltung, die die erfindungsgemäße Anordnung nutzt, und ein digitales Signal zur Weiterverarbeitung benötigt, dies ebenfalls bedient werden.

In anderen Worten kann also die Sensor-Transimpedanzverstärker-Kombination ohne eine integrative Komponente direkt das analoge Stromänderungssignal an einen Analogeingang einer Recheneinheit, beispielsweise eines vorhandenen DSP bzw. einer CPU, gegeben werden und die Integration des Signals zum Stromsignal digital erzeugt werden. Dies hat neben dem Vorteil eines reduzierten Schaltungsaufwands die Wirkung, dass durch die digitale Aufintegration durch zyklische oder strategische Nullung des Integrators ein Weglaufen des Integrationsergebnisses verhindert werden kann. Ein weiterer Vorteil ist ein durch die Digitalisierung gegebener deutlich höherer Dynamikbereich bzw. eine hohe Auflösung, die sich durch die erfindungsgemäße Aufintegration ergibt.

Weitere Vorteile und Details der Erfindung werden anhand der in den Figuren 1 bis 3 dargestellten Ausführungsbeispiele der Erfindung erläutert. Dabei zeigt
- FIGUR 1: schematisch ein Ausführungsbeispiel einer erfindungsgemäßen Anordnung mit drei Windungen als Messwertaufnehmer,
- FIGUR 2: schematisch ein alternatives Ausführungsbeispiel der erfindungsgemäßen Anordnung mit einem zylindrischen Formteil mit U-Querschnitt als Messwertaufnehmer,
- FIGUR 3: schematisch einen Transimpedanzverstärker als Ausführungsbeispiel des Transimpedanzverstärker der erfindungsgemäßen Anordnung.

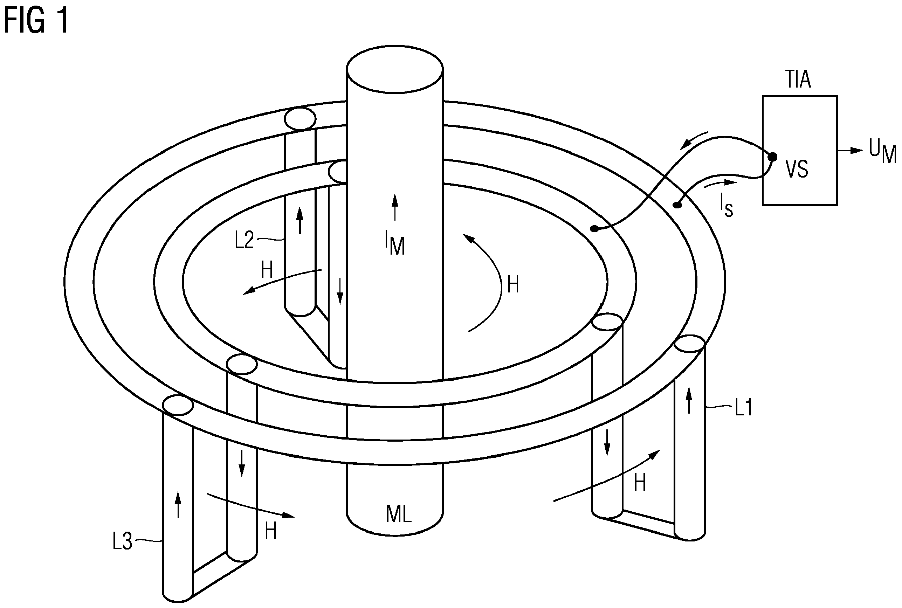

Bei den im Folgenden in FIGUR 1 bis FIGUR 3 erläuterten Ausführungsbeispielen handelt es sich um bevorzugte Ausführungsformen und Weiterbildungen der Erfindung.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Anordnungsanspruchs/Anordnungsansprüche und/oder Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind.

Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

Bei dem in der FIGUR 1 gezeigten Ausführungsbeispiel ist schematisch eine Ausgestaltungsvariante der erfindungsgemäßen Anordnung dargestellt und wird zusammen mit seiner Funktion und damit einem Ausführungsbeispiel des erfindungsgemäßen Verfahrens im Folgenden näher erläutert.

Das in FIGUR 1 dargestellte Ausführungsbeispiel basiert grundsätzlich ebenso wie die erfindungsgemäße Lösung an sich im Gegensatz zur Rogowski-Messmethode auf einer erfindungsgemäßen Kurzschlussstrommessung, die Prinzipbedingt durch die schnellere Ausräumung von Ladungsträgern und durch die deutlich geringere Anzahl von Sensorwindungen eine geringere Induktivität und geringere parasitäre Kapazitäten aufweist. Daraus resultiert, dass die Schaltung eine deutlich bessere Grenzfrequenz und eine geringere kapazitive Kopplung (dU/dt) zum Messkreis aufweist. Sie ist unter anderem dadurch insbesondere für resonante Schaltungen geeignet.

Diese und andere Vorteile werden bei der folgenden Beschreibung des Ausführungsbeispiels noch deutlicher.

Zu erkennen ist bei dem in FIGUR 1 dargestellten Ausführungsbeispiel, eine Ausgestaltung der Erfindung, bei der der zumindest eine zweite Stromleiter, erfindungsgemäß prinzipiell als eine oder eben mehrere Windungen L₁...Lₙ gestaltet sein kann, die aus einem ersten Stromleiter L1, einem zweiten Stromleiter L2 und einem dritten Stromleiter L3 gebildet sind.

Wie zu erkennen ist, bilden diese Stromleiter U-förmige Windungen, die um zwei ebenfalls um den zu messenden Stromleiter ML als zwei konzentrische Kreise ausgestaltete elektrisch leitende erste Körper K1 und zweite Körper K2 angeordnet und mit ihnen verbunden sind.

In der Darstellung ist ferner zu erkennen, dass die Stromleiter L1...L3 jeweils den ersten Körper K1 und den zweiten Körper K2 elektrisch leitend verbinden und somit parallelgeschaltet und konzentrisch um den zu messenden ersten Stromleiter ML herum, insbesondere gleichverteilt, positioniert sind.

In der FIGUR 1 ist ferner schematisch angedeutet, dass die Schenkel der drei Windungen L1...L3 senkrecht von den konzentrisch angeordneten ersten Körper K1 und zweiten Körper K2, die - in der FIGUR 1 nicht dargestellt - auf einem ersten Außenlayer einer Leiterplatte platziert sind, zum ebenfalls nicht dargestellten gegenüberliegenden zweiten Außenlayer laufen, wo kurze Leiterbahnstücke die als vertikale Durchkontaktierungen ausgestalteten Schenkel verbinden und so die U-Form ausbilden.

Die Windungen können also wie in der FIGUR 1 stark vereinfacht illustriert, als Kombination von Vias und Leiterbahnen in einer Leiterplatte realisiert sein.

In dem gezeigten Ausführungsbeispiel kann der zu messende Stromleiter ML durch ein Loch in der Leiterplatte geführt oder ebenfalls als Leiterbahn mit einer Via-Anordnung ausgeführt sein.

Im zu messenden ersten Stromleiter ML fließt zumindest zeitweise ein zu erfassender Wechselstrom IM. Dieser Wechselstrom erzeugt wiederum ein magnetisches Wechselfeld H, welches kreisförmig um den zu messenden Stromleiter ML läuft und in der FIGUR 1 durch einige das Magnetfeld symbolisierende Pfeile angedeutet ist. Dieses Magnetfeld H durchflutet seinerseits die in diesem Ausführungsbeispiel als Windungen ausgestaltete zweite Stromleiter L1...L3. Dadurch fließt, werden die Windungen nach dem erfindungsgemäßen Verfahren erfindungsgemäß über einen Transimpedanzverstärker TIA kurzgeschlossen, ein Kurzschlussstrom IS. Die Windungen L1...L3 stellen also Messwertaufnehmer dar. Der Kurzschluss wird also gemäß erfindungsgemäßem Verfahren durch einen gemäß Ausführungsbeispiel der erfindungsgemäßen Anordnung vorgesehenen Transimpedanzverstärker TIA realisiert.

Der durch das magnetische Wechselfeld induzierte Stromkreislauf kann erfindungsgemäß also nur über den Transimpedanzverstärker geschlossen werden.

Dieser transformiert den Kurzschlussstrom in eine Messpannung um. Die Messpannung ist proportional zur Stromänderung dI/dt.

Wird der absolute Strom benötigt, wird gemäß einer Weiterbildung der erfindungsgemäßen Anordnung das Messignal durch einen Integrator integriert, was in Folge zu einem stromproportionalen Messignal führt.

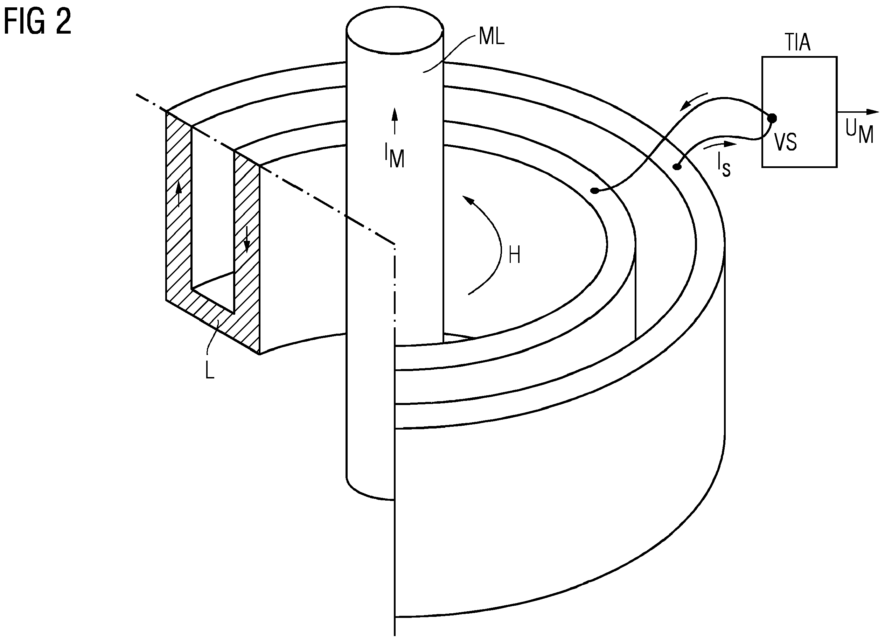

Alternativ zu diskreten, miteinander parallel geschalteten Windungen L1...3 ist auch eine Konstruktion denkbar, wie sie als Ausführungsbeispiel der erfindungsgemäßen Anordnung in FIGUR 2 dargestellt ist.

In diesem Ausführungsbeispiel besteht der Meßwertaufnehmer aus einem leitenden, U-förmigen Formteil L, das den zu messenden Stromleiter ML mit dem zu messenden Strom IM umschließt.

In der Schnittdarstellung der FIGUR 2 ist zu erkennen, dass das Formteil L ein zylindrisch ausgeformter Körper ist, welcher um die Symmetrieachse des Körpers verlaufend eine zylindrische Aussparung aufweist, also quasi ein Rohr bildet, dessen Rand ein um die Symmetrieachse laufenden U-Querschnitt aufweist. Das Verhältnis des Durchmessers des Rohres zu dessen Länge ist dabei in der Regel derart ausgestaltet, dass der Durchmesser größer als die Länge des Rohres ist, das Rohr also eher einer Scheibe mit einer kreisrunden Aussparung gleicht.

An einem Rohrende zeigen sich in der Draufsicht also zwei konzentrische Kreise, die dem ersten Körper K1 und dem zweiten Körper K2 entsprechen.

Auf dem gegenüberliegenden Rohrende ist dagegen in der Draufsicht ein Kreis um die Symmetrieachse verlaufend ausgebildet, der durch einen die Schenkel eines U bildendenden Boden entsteht.

Man könnte das Formteil L auch als unendliche Anzahl von verschmolzenen U-förmigen Windungen betrachten.

Auch in diesem Beispiel wird ein Transimpedanzverstärker TIA zur Umwandlung des Kurzschlussstromes IS in eine zur Stromänderung proportionale Spannung eingesetzt. Hierzu ist ein erster Eingang des Transimpedanzverstärkers TIA mit einem der zum ersten Körper K1 analogen Kreise des Rohrendes verbunden und ein zweiter Eingang des Transimpedanzverstärkers TIA ist mit dem anderen zum zweiten Körper K2 analogen Kreis leitend verbunden.

Auch bei diesem Beispiel kann ein Integrator das Ausgangssignal des Transimpedanzverstärkers TIA zu einer zur messenden Stromänderung des Messstromes IM proportionalen Spannung wandeln.

Die gezeigte Lösung mit einem als U-Formteil L ausgeformten Messwertaufnehmer kann beispielsweise von Vorteil sein, wenn für die Realisierung des erfindungsgemäßen Verfahrens ein Messwertaufnehmer benötigt wird, mit dem eine Schaltung bestückt wird.

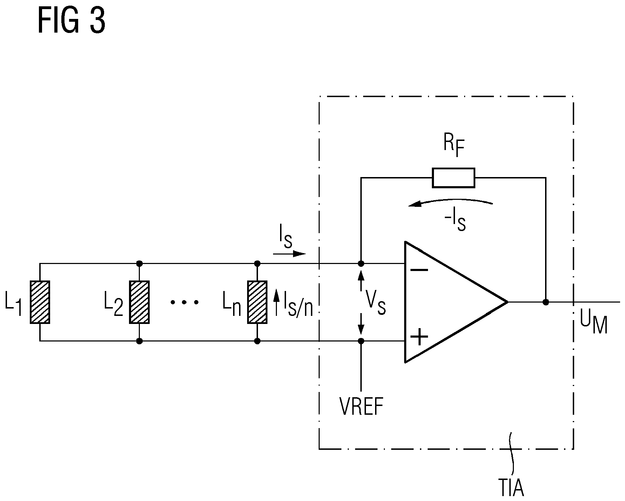

In FIGUR 3 ist nun schematisch ein prinzipieller Aufbau eines Ausführungsbeispiels eines erfindungsgemäßen Transimpedanzverstärkers TIA dargestellt. Die nach einem Ausführungsbeispiel der erfindungsgemäßen Anordnung möglichen Windungen, sind in diesem Beispiel dabei Schaltsymbole für Spulen, die erfindungsgemäß jeweils durch eine Schleife/Windung realisiert sein können.

Die in der FIGUR 3 dargestellten Spulen L₁...Lₙ stellen also eine Anzahl von n Schleifen dar, die wie in FIGUR 1 dargestellt parallelgeschaltet sind und deren zwei Anschlüsse an jeweils einem der beiden Eingänge des Transimpedanzverstärkers TIA - somit ebenfalls parallelgeschaltet - angeschlossen sind, welcher gemäß Ausführungsbeispiel als Operationsverstärker ausgestaltet ist, dessen - und + Eingang als Eingang des Transimpedanzverstärkers TIA dienen und der ferner erfindungsgemäß so beschaltet ist, dass ein Rückkopplungswiderstand RF vom Ausgang des Operationsverstärkers zum - Eingang des Operationsverstärkers führt.

Dabei wird durch den Rückkopplungswiderstand RF ein Kurzschlussstrom I_{S} im Stromkreis zu den Windungen L₁...Lₙ eingeprägt, der sich entsprechend des Kirchhoffschen Gesetzes auf die einzelnen Windungen gemäß Anzahl n der Windungen aufteilt. Die Summe der einzelnen Ströme I_{S}/n im Stromzweig entspricht betragsmäßig dem eingeprägten Kurzschlussstrom I_{S}, der durch das magnetische Wechselfeld H-Feld erzeugt wurde. Dass der Gesamtkurschlussstrom, sich durch die Summe von sich etwaig bildenden Zweigströmen bildet und dem eingeprägten Kurzschlussstrom I_{S}, der zum Eingang des Transimpedanzverstärkers geht, entspricht, gilt erfindungsgemäße immer, somit auch für die in den in Figur 1 und Figur 2 gezeigten Ausführungsbeispiele, wo die Zweigströme als Pfeile in den Leitern dargestellt sind. Da dadurch die -/+ Eingänge des Operationsverstärkers das gleiche Potential haben, kann hier von einem virtuellen Kurzschluss VS gesprochen werden. Aus der Sicht der Windungen ist es allerdings so, dass die Windungen L₁...Lₙ also in einem realen Kurzschluss betrieben werden.

Die Vorteile der Erfindung gegenüber den aus dem Stand der Technik bekannten Lösungen besteht unter anderem darin, dass das Messverfahren einfach in eine Leiterplatte integriert werden kann, da nur wenige Via-Leiterbahnen nötig sind, um den Sensor, den Messwertaufnehmer, zu realisieren.

In erfindungsgemäßen Versuchsaufbauten waren 3 Leiterschleifen ausreichend, um eine erfindungsgemäße Messwertaufnahme zu realisieren, wobei die Leiterschleifen L₁...Lₙ durch die Parallelschaltung zudem sehr einfach auszuführen sind.

Unter Anderem hierdurch weist die Anordnung und das Verfahren gemäß Erfindung einen wesentlichen Vorteil gegenüber aus dem Stand der Technik versuchten Realisierungen eine Rogowsky-Spule in eine Leiterplatte zu integrieren auf.

Gemäß den aus dem Stand der Technik bekannten Ansätzen mit einer Rogowski-Spule liefert jede Leiterschleife nur im einstelligen Millivolt-Bereich liegende Signale. Daher ist gemäß Stand der Technik eine Anordnung von 100 bis mehrere hundert Schleifen erforderlich, was auf der Leiterplatte große durchlöcherte Strukturen ergibt.

Im Gegensatz dazu liefert die erfindungsgemäße Lösung ein, insbesondere im Vergleich zum Stand der Technik, relativ kräftiges Stromsignal, welches durch einen Transimpedanzverstärker TIA leicht in ein Spannungssignal transformiert und ausgewertet werden kann.

Durch das kräftige Signal wird es zudem auch möglich kleine Schleifenkonstruktionen in den Innenlayern einer Leiterplatte zu benutzen, um beispielsweise in den Außenlayern eine Schirmung der Koppelkapazität oder den Stromzweig für den zu messenden Strom IM zu realisieren.

Der bei Bedarf einsetzbare Integrator kann konventionell über eine im Wesentlichen analoge Schaltung oder vorzugsweise nach einer AD-Wandlung auch digital mittels einer Recheneinheit (DSP/CPU) bereitgestellt werden. Dies ist insbesondere von Vorteil, wenn so eine Recheneinheit bereits Teil der zu messenden Schaltung ist und somit nur eine weitere Funktion erfüllt. Hierdurch wird Platz gespart und zusätzliche Bauteilekosten entfallen.

Weiterhin ist bei der erfindungsgemäßen Lösung von Vorteil, dass der zu messende Zweig galvanisch von dem Messzweig getrennt ist. Dies überwindet beispielsweise die Nachteile, die bei einer Stromerfassung mittels Shuntmessung gegeben sind.

Verglichen mit den aus dem Stand der Technik bekannten Ansätzen zur Stromerfassung, die im Gegensatz zu Erfindung auf Stromtransformatoren, Magnetfeld-Sensoren und aus dem Stand der Technik bekannten Ansätzen mit Rogowski-Spulen beruhen, ergibt sich weiterhin der Vorteil, dass das Messprinzip frequenzlimitierende Faktoren wie Kernmaterialien, Wickelkapazitäten, Serieninduktivität und Limitationen durch Kompensationseinrichtungen nicht hat.

Messungen der Pickup-Konfiguration für den Versuch zeigen, dass die erfindungsgemäße Lösung eine Resonanzfrequenz im mittleren zweistelligen MHz-Bereich aufweist.

Im Gegensatz zu kommerziell erwerbbaren Komponenten wie Shunt, Magnetsensoren und Stromtransformatoren kann die Messeinrichtung zudem an dem zu messenden Strom I_{M} flexibel angepasst werden. Insbesondere bei Integration der Erfindung auf einer Leiterplatte, entstehen keine bzw. kaum Kosten für den Sensor, da eine Leiterplatte ohnehin vorhanden ist. Insbesondere bei der Nutzung von VIA-Verbindungen und Leiterbahnen für die Windungen, steht lediglich der Transimpedanzverstärker und/oder der Integrator auf der Kostenseite.

## Patentansprüche

1. Verfahren zur Erfassung eines Stroms eines ersten Stromleiters einer, insbesondere zumindest teilweise auf einer Leiterplatte aufgebrachten, Schaltung,
**dadurch gekennzeichnet, dass**
a) ein erster in einer Ebene einen geschlossenen Stromkreis ausbildender Strom leitender Körper und ein zweiter in der Ebene einen geschlossenen Stromkreis ausbildender Strom leitender Körper um den Leiter derart platziert werden, dass die ausgebildeten Stromkreise der Körper in der Ebene konzentrisch, insbesondere kreisförmig, um den in ihrem geometrischen Mittelpunkt platzierten durch die Ebene senkrecht verlaufenden den zu erfassenden Strom führenden ersten Stromleiter angeordnet und betrieben werden, wobei die Körper derart geformt werden und/oder funktional derart miteinander verbunden und betrieben werden, dass sie durch zumindest einen senkrecht zu der Ebene im Querschnitt ein U-Profil ausbildenden, zweiten Stromleiter leitend verbunden sind, wobei jeweils die beiden Schenkel des U-Profils im Querschnitt auf der jeweiligen Querschnittsebene liegen und der erste Schenkel des U-Profils mit dem ersten Körper über einen ersten Verbindungspunkt verbunden ist und der zweite Schenkel des U-Profils mit dem zweiten Körper über einen zweiten Verbindungspunkt verbunden ist, insbesondere der erste Verbindungspunkt und der zweite Verbindungspunkt des U-Profils mit dem Mittelpunkt auf einer Geraden liegen
b) der erste Körper mit einem ersten Eingang eines, insbesondere durch einen Operationsverstärker ausgestalteten, Transimpedanzverstärkers und der zweite Körper mit einem zweiten Eingang des Transimpedanzverstärkers derart verbunden betrieben werden, dass durch den Transimpedanzverstärker ein Kurzschluss bewirkbar ist, wobei ein im Fall eines bewirkten Kurzschlusses durch den ersten Körper, den zweiten Körper und dem ausgeformten und/oder funktional verbundenen zumindest einen zweiten Stromleiter fließender Kurzschlussstrom vom Transimpedanzverstärker als Eingangsgröße des Transimpedanzverstärkers eine Spannung an einem Ausgang des Transimpedanzverstärkers erzeugt.

2. Verfahren nach dem vorherigen Anspruch,
**dadurch gekennzeichnet, dass**
der erste Körper und der zweite Körper derart funktional verbunden und betrieben werden, dass jeder Punkt des ersten geschlossenen Stromkreises mit dem parallelen Punkt des zweiten Stromkreises über eine im Querschnitt ein U-Profil ausbildende leitende Verbindung derart verbunden ist, dass ein um den Mittelpunkt umlaufender Querschnitt stets ein U-Profil aufweist, so dass der zumindest eine zweite Stromleiter mit dem ersten Körper und dem zweiten Körper als ein umlaufendes U-Profil ausbildender Hohlkörper ausgebildet ist.

3. Verfahren nach einem der vorherigen Ansprüche,
**dadurch gekennzeichnet, dass**
der erste Körper, der zweite Körper und/oder der zumindest eine zweite Stromleiter, zumindest teilweise als Leiterbahnen einer Leiterplatte betrieben werden.

4. Verfahren nach dem vorhergehenden Anspruch,
**dadurch gekennzeichnet, dass**
der erste Stromleiter, der zumindest eine zweite Stromleiter und/oder die funktionalen Verbindungen als so genannte "Vertical Interconnect Access"-, Via-Verbindungen durch die Leiterplatte betrieben werden.

5. Verfahren nach einem der Ansprüche 3 bis 4,
**dadurch gekennzeichnet, dass**
der erste Körper, der zweite Körper und/oder der zumindest eine zweite Stromleiter derart ausgeformt und/oder funktional verbunden wird, dass er in Innenlayern der Leiterplatte betrieben wird.

6. Verfahren nach einem der vorhergehenden Ansprüche,
**dadurch gekennzeichnet, dass**
die Spannung am Ausgang des Transimpedanzverstärkers einem eine Integration durchführenden ersten Modul als Eingangssignale zugeführt wird.

7. Verfahren nach dem Anspruch 6,
**dadurch gekennzeichnet, dass** das Modul derart mit dem Transimpedanzverstärker funktional verbunden und betrieben wird, dass das erste Modul als Integratorschaltung wirkt.

8. Verfahren nach einem der Ansprüche 1 bis 5,
**dadurch gekennzeichnet, dass**
ein zweites Modul derart mit dem Transimpedanzverstärker funktional verbunden und betrieben wird, dass das zweite Modul als Analog/Digitalwandler wirkt, wobei der analoge Wert der Spannung am Ausgang des Transimpedanzverstärkers zu einer digitalen Repräsentation des Wertes der Spannung derart gewandelt und derart funktional mit einer, insbesondere als "Digital Signalling Processor", DSP, so genannten "Central Programming Unit", CPU, oder so genannten, "Application-Specific Integrated Circuit" Schaltung, ASIC, ausgestalteten, Recheneinheit verbunden und betrieben wird, dass die Integration durch die Recheneinheit erfolgt.

9. Anordnung zur Erfassung eines Stroms eines ersten Stromleiters einer, insbesondere zumindest teilweise auf einer Leiterplatte aufgebrachten, Schaltung,
**dadurch gekennzeichnet, dass**
a) ein erster in einer Ebene einen geschlossenen Stromkreis ausbildender Strom leitender Körper und ein zweiter in der Ebene einen geschlossenen Stromkreis ausbildender Strom leitender Körper um den Leiter derart platziert sind, dass die ausgebildeten Stromkreise der Körper in der Ebene konzentrisch, insbesondere kreisförmig, um den in ihrem geometrischen Mittelpunkt platzierten durch die Ebene senkrecht verlaufenden den zu erfassenden Strom führenden ersten Stromleiter angeordnet sind, wobei die Körper derart geformt und/oder funktional derart miteinander verbunden sind, dass sie durch zumindest einen senkrecht zu der Ebene im Querschnitt ein U-Profil ausbildenden, zweiten Stromleiter leitend verbunden sind, wobei jeweils die beiden Schenkel des U-Profils im Querschnitt auf der jeweiligen Querschnittsebene liegen und der erste Schenkel des U-Profils mit dem ersten Körper über einen ersten Verbindungspunkt verbunden ist und der zweite Schenkel des U-Profils mit dem zweiten Körper über einen zweiten Verbindungspunkte verbunden ist, insbesondere der erste Verbindungspunkt und der zweite Verbindungspunkt des U-Profils mit dem Mittelpunkt auf einer Geraden liegt,
b) der erste Körper mit einem ersten Eingang eines, insbesondere durch einen Operationsverstärker ausgestalteten, Transimpedanzverstärkers und der zweite Körper mit einem zweiten Eingang des Transimpedanzverstärkers derart ausgestaltet und verbunden sind, dass durch den Transimpedanzverstärker ein Kurzschluss bewirkbar ist, wobei ein im Fall eines bewirkten Kurzschlusses durch den ersten Körper, den zweiten Körper und den ausgeformten und/oder funktional verbundenen zumindest einen zweiten Stromleiter fließender Kurzschlussstrom vom Transimpedanzverstärker als Eingangsgröße des Transimpedanzverstärkers eine Spannung an einem Ausgang des Transimpedanzverstärkers erzeugt.

10. Anordnung nach dem vorherigen Anspruch,
**dadurch gekennzeichnet, dass**
der erste Körper und der zweite Körper derart funktional verbunden und ausgestaltet ist, dass jeder Punkt des ersten geschlossenen Stromkreises mit dem parallelen Punkt des zweiten Stromkreises über eine im Querschnitt ein U-Profil ausbildende leitende Verbindung derart verbunden ist, dass ein um den Mittelpunkt umlaufender Querschnitt stets ein U-Profil aufweist, so dass der zumindest eine zweite Stromleiter mit dem ersten Körper und dem zweiten Körper als ein umlaufendes U-Profil ausbildender Hohlkörper ausgebildet ist.

11. Anordnung nach einem der vorherigen Ansprüche,
**dadurch gekennzeichnet, dass**
der erste Körper, der zweite Körper und/oder der zumindest eine zweite Stromleiter, zumindest teilweise als Leiterbahnen einer Leiterplatte ausgestaltet ist.

12. Anordnung nach dem vorhergehenden Anspruch,
**dadurch gekennzeichnet, dass**
der erste Stromleiter, der zumindest eine zweiten Stromleiter und/oder die funktionalen Verbindungen als so genannte "Vertical Interconnect Access"-, Via-Verbindungen durch die Leiterplatte ausgestaltet ist/sind.

13. Anordnung nach einem der Ansprüche 11 bis 12,
**dadurch gekennzeichnet, dass**
der erste Körper, der zweite Körper und/oder der zumindest ein zweite Stromleiter derart ausgeformt und/oder funktional verbunden ist/sind, dass er/sie in Innenlayern der Leiterplatte angeordnet ist/sind.

14. Anordnung nach einem der Ansprüche 9 bis 13,
**dadurch gekennzeichnet, dass**
die Spannung am Ausgang des Transimpedanzverstärkers einem eine Integration durchführenden ersten Modul als Eingangssignal angelegt ist.

15. Anordnung nach dem Anspruch 14,
**dadurch gekennzeichnet, dass**
das erste Modul derart mit dem Transimpedanzverstärker funktional verbunden und ausgestaltet ist, dass das erste Modul als Integratorschaltung wirkt.

16. Anordnung nach einem der Ansprüche 9 bis 13,
**dadurch gekennzeichnet, dass**
ein zweites Modul derart mit dem Transimpedanzverstärker funktional verbunden und ausgestaltet ist, dass das zweite Modul als Analog/Digitalwandler wirkt, wobei der analoge Wert der Spannung am Ausgang des Transimpedanzverstärkers zu einer digitalen Repräsentation des Wertes der Spannung derart gewandelt und derart funktional einer, insbesondere als "Digital Signalling Processor"-, DSP-, so genannten "Central Programming Unit"-, CPU-, oder so genannten, "Application-Specific Integrated Circuit"-, ASIC-Schaltung, ausgestalteten, Recheneinheit als Eingangssignal angelegt ist, dass die Integration durch die Recheneinheit erfolgt.
